# EUROPEAN PATENT SPECIFICATION

(11) **EP 4 261 623 B1**
(45) Date of publication and mention of the grant of the patent: **28.08.2024**
(21) Application number: 22213666.5
(22) Date of filing: 15.12.2022
(51) Int. Cl.: G04F 10/00, H03M 1/08

(54) **METHOD FOR RECOGNIZING ORDER OF SIGNALS**
VERFAHREN ZUR ERKENNUNG DER REIHENFOLGE VON SIGNALEN
PROCÉDÉ DE RECONNAISSANCE DE L'ORDRE DE SIGNAUX

(30) Priority: 14.04.2022 PL 44094422
(43) Date of publication of application: 18.10.2023
(73) Proprietor: Akademia Gorniczo-Hutnicza im. Stanislawa Staszica w Krakowie, 30-059 Krakow (PL)
(72) Inventor: Koscielnik, Dariusz, 31-431 Kraków (PL); Szyduczynski, Jakub, 22-460 Szczebrzeszyn (PL); Miskowicz, Marek, 31-621 Kraków (PL); Jurasz, Konrad, 34-331 Swinna (PL)
(74) Representative: Wlasienko, Jozef

(56) References cited:
- KOSCIELNIK DARIUSZ ET AL: "Optimized design of successive approximation time-to-digital converter with single set of delay lines", 2016 SECOND INTERNATIONAL CONFERENCE ON EVENT-BASED CONTROL, COMMUNICATION, AND SIGNAL PROCESSING (EBCCSP), IEEE, 13 June 2016 (2016-06-13), pages 1 - 8, XP032983233, DOI: 10.1109/EBCCSP.2016.7605284
- ABAS M A ET AL: "Embedded high-resolution delay measurement system using time amplification", 20070305, vol. 1, no. 2, 5 March 2007 (2007-03-05), pages 77 - 86, XP006028355
- ABAS M A ET AL: "Design of sub-10-picoseconds on-chip time measurement circuit", DESIGN, AUTOMATION AND TEST IN EUROPE CONFERENCE AND EXHIBITION, 2004. PROCEEDINGS FEB. 16-20, 2004, PISCATAWAY, NJ, USA,IEEE, 1730 MASSACHUSETTS AVE., NW WASHINGTON, DC 20036-1992 USA, vol. 2, 16 February 2004 (2004-02-16), pages 804 - 809, XP010684769, ISBN: 978-0-7695-2085-8, DOI: 10.1109/DATE.2004.1268980
- SZYDUCZYNSKI J ET AL: "Behavioral Modelling and Optimization of a Cyclic Feedback-Based Successive Approximation TDC with Dynamic Delay Equalization", 2019 5TH INTERNATIONAL CONFERENCE ON EVENT-BASED CONTROL, COMMUNICATION, AND SIGNAL PROCESSING (EBCCSP), IEEE, 27 May 2019 (2019-05-27), pages 1 - 9, XP033617077, DOI: 10.1109/EBCCSP.2019.8836859

## Description

The subject of the invention is a method for recognizing an order of signals that can be applied in control and measurement systems and automation, but mainly in analog-to-digital conversion of the TDC type (time-to-digital conversion), in which the analog input quantity is a time interval. TDC converters of this type are used e.g. in: laser rangefinders, digital phase locked loops (DPLL), positron emission tomography and post-production tests of time parameters of very large-scale integration (VLSI) integrated circuits.

From the publication: M. A. Abas, G. Russell and D. J. Kinniment, "Design of Sub-10-Picoseconds On-Chip Time Measurement Circuit" a method for recognizing an order of signals by means of a MUTEX circuit (mutual exclusion) is known. In this method, a source signal is fed to a set input of the MUTEX circuit, whereas a reference signal is fed to a reset input of the MUTEX circuit. The one of the mentioned signals that will be first to enter its active state, will be indicated as a leading signal by means of the MUTEX circuit. One of the two outputs of the MUTEX circuit that corresponds to this signal will be then put into active state, confirming that the order of signals was finally settled. The active state of the other of the signals that reaches the MUTEX circuit will not affect the state of the outputs of this system.

From the publication: M. A. Abas, G. Russell and D. J. Kinniment, "Built-in time measurement circuits - a comparative design study" IET Comput. Digit. Tech., 2007, 1, (2), pp. 87 - 97 a method of analog-to-digital conversion of the TDC type (time-to-digital conversion) is known, in which the coded analog quantity is a time interval. This interval is represented by a distance of time between the moments in which a source signal and a reference signal successively enter their active states. An amount of the measured interval is determined by means of the successive approximation method and finally presented in the form of an n-bit output digital word. The processing is carried out in a system composed of n sequentially connected cells. Each of the cells first waits until active state appears on one of its signal inputs, which means that the leading one of the signals has just reached this cell. A reference delay is then introduced into the leading signal path, which is twice as small as the reference delay introduced by the previous cell and simultaneously twice as large as the reference delay introduced by the next cell. However, the given cell does not introduce the reference delay into the path of the second, later signal. Furthermore, each of the cells, based on the path configuring method of both signals it has introduced, assigns an appropriate value to a bit having index x of the n-bit output digital word, wherein the position of a given bit having index x in the digital word corresponds to the location of the considered cell in the converter structure. The processing ultimately leads to the alignment in time of the moments in which both signals enter active state. This alignment can be achieved with an accuracy not worse than the absolute resolution of a given converter. The absolute value of the measured time interval can therefore also be determined as a difference of sums of reference delays introduced into the paths of each signal.

The order in which the active states of the source signal and of the reference signal reach a given cell are recognized by means of a MUTEX circuit. Occurrence of the leading active state on one of the two inputs of this circuit causes the corresponding of its two outputs to enter active state. These outputs control the configuration of two multiplexers. By using them, the reference delay is introduced into the path of the leading signal and simultaneously it is not introduced into the path of the second, later signal. However, since the propagation times of information through the MUTEX circuit and each of the multiplexers are non-zero, in the paths of both signals in each cell of the converter delay elements are permanently included, by means of which the influence of the propagation delays of the mentioned elements is compensated.

From the publication: D. J. Kinniment, O. V. Maevsky, A. Bystrov, G. Russell and A. V. Yakovlev, "On-Chip structures for Timing Measurement and Test" a metastability effect of a MUTEX circuit is known. This circuit is characterized by a constant and small propagation delay in a situation where active states on both its inputs do not appear quasi-simultaneously. However, if both inputs of the MUTEX circuit enter their active states quasi-simultaneously, the response time of the MUTEX circuit increases rapidly. In this situation, long after entering active states by both inputs of the MUTEX circuit, both of its outputs still remain inactive. This effect cannot be fully compensated for by the delays permanently included in the paths of both signals, because the absolute value of the inaccuracy of each of such large delays, resulting from the dispersion of technological processes, becomes significantly greater than the resolution of the converter, falsifying the results of each of the measurements performed. Thus, in the case of metastability of the MUTEX circuit, which however does not happen often, the active signal finally appears on one of the outputs of this circuit with a large and uncompensated delay. This delay makes it impossible to properly configure further parts of the paths of both signals before the active states of these signals reach the considered parts. As a result of the above, at a given stage of processing, none of the signal paths will contain the required reference delay or, in another implementation of the converter, the paths of both signals will contain the same reference delay. In both cases, the processing result will be burdened with an error, the value of which may reach even half of the processing range, depending on the stage of processing where metastability phenomenon occurs.

A method for recognizing an order of signals according to the invention consists in detecting, by means of a main MUTEX circuit, executed during an analog-to-digital conversion step used to determine a value of a bit having index x of an n-bit output digital word, that a source signal was the first to enter its active state, or that a reference signal was the first to enter its active state. A path configuration circuit is signaled by means of a first output of the main MUTEX circuit that the source signal was the first to enter its active state. The path configuration circuit is signaled by means of a second output of the main MUTEX circuit that the reference signal was the first to enter its active state. The source signal is fed by means of a first delay circuit to an input of a source path of the path configuration circuit. Simultaneously the reference signal is fed by means of a second delay circuit to an input of a reference path of the path configuration circuit. Propagation time of the first delay circuit is equal to propagation time of the second delay circuit and is longer than a nominal propagation delay of the main MUTEX circuit.

The essence of the solution lies in that metastability of the main MUTEX circuit is detected by means of an additional MUTEX circuit, by controlling the delay with which the first output of the main MUTEX circuit or the second output of the main MUTEX circuit is put into active state by means of the main MUTEX circuit. This delay refers to the moment in which the source signal was the first to enter its active state or the reference signal was the first to enter its active state. The metastability of the main MUTEX circuit is signaled by means of the additional MUTEX circuit by bringing a second output of the additional MUTEX circuit into active state. Entering active state by the source signal or entering active state by the reference signal is detected by means a first gate and is signaled by means of an additional delay circuit to the additional MUTEX circuit, bringing a reset input of the additional MUTEX circuit into active state. Propagation time of the additional delay circuit is shorter than the propagation time of the first delay circuit and simultaneously is longer than the nominal propagation delay of the main MUTEX circuit. Entering active state by the first output of the main MUTEX circuit or entering active state by the second output of the main MUTEX circuit is detected and is signaled by means of a second gate to the additional MUTEX circuit, bringing a set input of the additional MUTEX circuit into active state. To the bit having index x of the n-bit output digital word a value is assigned by means of an output module in the following manner. If during the analog-to-digital conversion step used to determine the value of the bit having index x of the n-bit output digital word, metastability of the main MUTEX circuit is signaled by means of the additional MUTEX circuit and a priority input of the output module is put into active state by means of the second output of the additional MUTEX circuit, then to the bit having index x and to all possible less significant bits of the n-bit output digital word default logical states are assigned by means of the output module. Simultaneously, the state indicated by means of the first output of the main MUTEX circuit to a data input of the output module is ignored by the output module during this and any subsequent analog-to-digital conversion steps. If, however, during the analog-to-digital conversion step used to determine the value of the bit having index x of the n-bit output digital word, metastability of the main MUTEX circuit is not signaled by means of the additional MUTEX circuit and the priority input of the output module is kept by the second output of the additional MUTEX circuit in inactive state and metastability is not signaled during any of possible earlier analog-to-digital conversion steps used to determine values of more significant bits of the n-bit output digital word, then to the bit having index x of the n-bit output digital word a logical state according to the state of the data input of the output module is assigned by means of the output module. Thus, if the data input of the output module is put into active state by means of the first output of the main MUTEX circuit, then to the bit having index x of the n-bit output digital word a logical state one is assigned by means of the output module. Otherwise, when the data input of the output module is kept in inactive state by means of the first output of the main MUTEX circuit, to the bit having index x of the n-bit output digital word a logical state zero is assigned by means of the output module.

It is advantageous if the active state of the source signal, of the reference signal, of the first output of the main MUTEX circuit and of the second output of the main MUTEX circuit as well as of a first output of the additional MUTEX circuit and of the second output of the additional MUTEX circuit is a logical high state. Then, by means of the first gate and by means of the second gate a logical OR function is implemented.

It is also advantageous if the active state of the source signal, of the reference signal, of the first output of the main MUTEX circuit and of the second output of the main MUTEX circuit as well as of the first output of the additional MUTEX circuit and of the second output of the additional MUTEX circuit is a logical low state. Then, by means of the first gate and by means of the second gate a logical AND function is implemented.

It is advantageous if the default logical states are assigned by means of the output module to selected bits of the n-bit output digital word in such a way that to the bit having index x of the n-bit output digital word a logical state zero is assigned by means of the output module. Simultaneously, to all possible less significant bits of the n-bit output digital word logical states one are assigned by means of the output module.

It is also advantageous if the default logical states are assigned by means of the output module to selected bits of the n-bit output digital word in such a way that to the bit having index x of the n-bit output digital word a logical state one is assigned by means of the output module. Simultaneously, to all possible less significant bits of the n-bit output digital word logical states zero are assigned by means of the output module.

The advantage of the solution lies in ensuring the correct operation of the TDC-type analog-to-digital converter even in a situation where metastability of the MUTEX circuit occurs at any stage of processing. In such a situation, to all bits of this part of the output digital word which due to the metastability of the MUTEX circuit is at risk of being falsified, a predetermined default value will be assigned. The final value of the output digital word obtained in this way differs by at most one from the result that could be obtained in an ideal, completely metastability-free converter.

The solution also allows to interrupt the analog-to-digital conversion process, during which metastability of the MUTEX circuit occurred. In this way both the time and the amount of energy necessary to obtain the correct processing result are reduced.

The subject of the invention is explained in exemplary embodiments in the drawing which shows:
- Fig. 1 -: a diagram of a system for recognizing an order of signals.
- Fig. 2 -: a diagram of a MUTEX circuit reacting to an active state in the form of a logical high state, containing an asynchronous RS flip-flop composed of NAND logic gates and a simple filter.

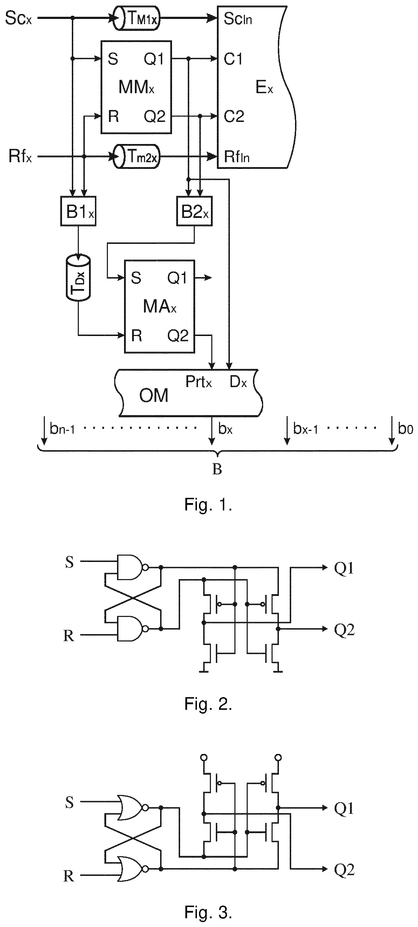

- Fig. 2 -: a diagram of a MUTEX circuit reacting to an active state in the form of a logical low state, containing an asynchronous RS flip-flop composed of NOR logic gates and an inverted filter.

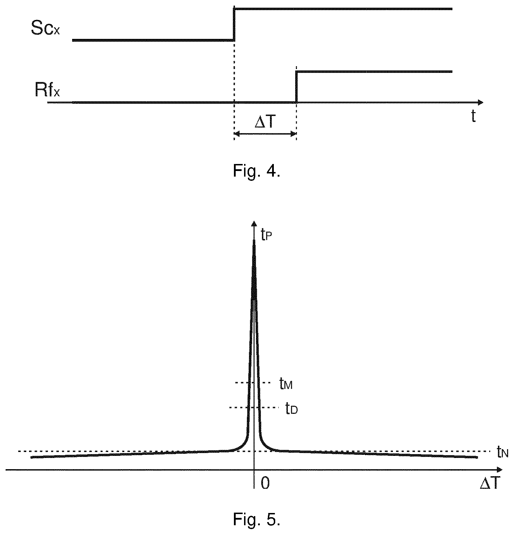

- Fig. 4 -: a time interval ΔT separating moments of entering active states by a source signal Scₓ and by a reference signal Rfₓ.
- Fig. 5 -: a propagation delay t_{P} of the main MUTEX circuit MMₓ as a function of time interval ΔT.

According to the invention, a method for recognizing an order of signals consists in detecting, by means of a main MUTEX circuit MMₓ, which of two signals reaches earlier a cell used to determine a value of a bit having index x, bₓ, of an n-bit output digital word B in a TDC-type analog-to-digital converter, using the successive approximation method. The first of the signals controlled by means of the main MUTEX circuit MMₓ is a source signal Scₓ, whereas the second signal is a reference signal Rfₓ. The arrival of the leading signal to the considered cell of the analog-to-digital converter is recognized by means of a set input S of the main MUTEX circuit MMₓ or by a reset input R of the main MUTEX circuit MMₓ, put into active state by means of, respectively, the source signal Scₓ or the reference signal Rfₓ. In this exemplary solution the active state is represented by a logical high state. An appearance of the leading signal is signaled to a path configuration circuit Eₓ by means of a first output Q1 of the main MUTEX circuit MMₓ, if the leading signal is the source signal Scₓ, or by means of a second output Q2 of the main MUTEX circuit MMₓ, if the leading signal is the reference signal Rfₓ. A propagation delay t_{P} of the main MUTEX circuit MMₓ is compensated in excess for the source signal Scₓ and for the reference signal Rfₓ by means of, respectively, a first delay circuit T_{M1x} and a second delay circuit T_{M2x}. Propagation time t_{M} of the first delay circuit T_{M1x} is equal to propagation time t_{M} of the second delay circuit T_{M2x} and is five times longer than a nominal propagation delay t_{N} of the main MUTEX circuit MMₓ. Thereby, in the absence of metastability of the main MUTEX circuit MMₓ it is guaranteed, by means of the first delay circuit T_{M1x} and the second delay circuit T_{M2x}, that the source signal Scₓ and the reference signal Rfₓ will reach, respectively, an input of a signal path Sc_{In} of the path configuration circuit Eₓ and an input of a reference path Rfₗₙ of the path configuration circuit Eₓ only after the path configuration circuit Eₓ has been signaled by means of the main MUTEX circuit MMₓ, which of these signals is the leading one. In this exemplary solution the active state of the first output Q1 of the main MUTEX circuit MMₓ and of the second output Q2 of the main MUTEX circuit MMₓ as well as of a first output Q1 of an additional MUTEX circuit MAₓ and of a second output Q2 of the additional MUTEX circuit MMₓ is a logical high state.

The metastability of the main MUTEX circuit MMₓ is detected by means of the additional MUTEX circuit MAₓ, by comparing the propagation delay t_{P} of the main MUTEX circuit MMₓ with propagation time to of an additional delay circuit T_{Dx}. The propagation time to of the additional delay circuit T_{Dx} is four times longer than the nominal propagation delay t_{N} of the main MUTEX circuit MMₓ and is shorter than the propagation time t_{M} of the first delay circuit T_{M1x} and of the second delay circuit T_{M2x}. The beginning of an interval of the propagation delay t_{P} of the main MUTEX circuit MMₓ is detected by means of a first gate B1ₓ acting in this exemplary solution as a logical sum, is delayed by means of the additional delay circuit T_{Dx} and is signaled to the additional MUTEX circuit MAₓ by means of a reset input R of the additional MUTEX circuit MAₓ. The end of the interval of the propagation delay t_{P} of the main MUTEX circuit MMₓ is detected by means of a second gate B2ₓ acting in this exemplary solution as a logical sum and is signaled to the additional MUTEX circuit MAₓ by means of a set input S of the additional MUTEX circuit MAₓ. If the interval of the propagation delay t_{P} of the main MUTEX circuit MMₓ is longer than the propagation time to of the additional delay circuit T_{Dx}, then the detected metastability of the main MUTEX circuit MMₓ is signaled by means of the additional MUTEX circuit MAₓ to an output module OM, bringing a priority input Prtₓ of the output module OM into active state by means of the second output Q2 of the additional MUTEX circuit MAₓ.

If the metastability of the main MUTEX circuit MMₓ is detected by means of the additional MUTEX circuit MAₓ in the cell of the analog-to-digital converter used to determine a value of the bit having index x, bₓ, of the n-bit output digital word B, to the bit having index x, bₓ, and to all possible less significant bits bₓ₋₁, ..., b₀ of the n-bit output digital word B default logical states are assigned by means of the output module OM. In this exemplary solution, to the bit having index x, bₓ, of the n-bit output digital word B a logical state zero is assigned by means of the output module OM, and to all possible less significant bits bₓ₋₁, ..., b₀ of the n-bit output digital word B logical states one are assigned by means of the output module OM. Simultaneously, the state indicated by means of the first output Q1 of the main MUTEX circuit MMₓ to a data input Dₓ of the output module OM is ignored by means of the output module OM. In such case the output module OM ignores also the states indicated to the data input of the output module OM in all possible subsequent cells of the analog-to-digital converter, used to determine values of less significant bits bₓ, ..., b₀ of the n-bit output digital word B.

If no metastability of the main MUTEX circuit MMₓ is detected by means of the additional MUTEX circuit MAₓ in the cell of the analog-to-digital converter used to determine a value of the bit having index x, bₓ, of the n-bit output digital word B and provided that no metastability is detected in any of the cells of the analog-to-digital converter, used to determine values of more significant bits bₙ₋₁, ..., bₓ₊₁ of the n-bit output digital word B, to the bit having index x, bₓ, of the n-bit output digital word B a logical state according to the state of the data input Dₓ of the output module OM is assigned by means of the output module OM. If the data input Dₓ of the output module OM is put into active state by means of the first output Q1 of the main MUTEX circuit MMₓ, to the bit having index x, bₓ, of the n-bit output digital word B a logical state one is assigned by means of the output module OM. Otherwise, when the data input Dₓ of the output module OM is kept in inactive state by means of the first output Q1 of the main MUTEX circuit MMx, to the bit having index x, bₓ, of the n-bit output digital word B a logical state zero is assigned by means of the output module OM.

Another method for recognizing an order of signals, according to the invention, differs from the previous one in that the active state of the source signal Scₓ and the active state of the reference signal Rfₓ is represented by a logical low state. The active state of the first output Q1 of the main MUTEX circuit MMₓ and of the second output Q2 of the main MUTEX circuit MMₓ as well as of the first output Q1 of the additional MUTEX circuit MAₓ and of the second output Q2 of the additional MUTEX circuit MMₓ is also a logical low state. Moreover, the first gate B1ₓ and the second gate B2ₓ function as a logical product in this exemplary solution.

A further method for recognizing an order of signals, according to the invention, differs from the previous ones in that, if to selected bits of the n-bit output digital word B the default logical states are assigned by means of the output module OM, starting from the bit having index x, bₓ, then to the bit having index x, bₓ, of the n-bit output digital word B a logical state one is assigned by means of the output module OM, and to all possible less significant bits bₓ₋₁, ..., b₀ of the n-bit output digital word B logical states zero are assigned by means of the output module OM.

According to the invention, a system for recognizing an order of signals, in a first exemplary solution (fig. 1), in a cell of an analog-to-digital converter, used to determine a value of a bit having index x, bₓ, of an n-bit output digital word B, comprises a main MUTEX circuit MMₓ. The main MUTEX circuit MMₓ is provided with a set input S, a reset input R, a first output Q1 and a second output Q2. The set input S of the main MUTEX circuit MMₓ is connected to an input of a source signal Scₓ, and the reset input R of the main MUTEX circuit MMₓ is connected to an input of a reference signal Rfₓ. The first output Q1 of the main MUTEX circuit MMₓ is connected to a first control input C1 of a path configuration circuit Eₓ, whereas the second output Q2 of the main MUTEX circuit MMₓ is connected to a second control input C2 of the path configuration circuit Eₓ. The input of the source signal Scₓ is furthermore connected to an input of a first delay circuit T_{M1x}, whose output is connected to an input of a source path Sc_{In} of the path configuration circuit Eₓ. On the other hand, the input of the reference signal Rfₓ is connected to an input of a second delay circuit T_{M2x}, whose output is connected to an input of a reference path Rfₗₙ of the path configuration circuit Eₓ. Propagation time t_{M} of the first delay circuit T_{M1x} is equal to propagation time t_{M} of the second delay circuit T_{M2x} and is five times longer than a nominal propagation delay t_{N} of the main MUTEX circuit MMₓ. The input of the source signal Scₓ is connected to a first input of a first gate B1ₓ, whose second input is connected to the input of the reference signal Rfₓ. An output of the first gate B1ₓ is in turn connected to an input of an additional delay circuit T_{Dx}, whose output is connected to a reset input R of an additional MUTEX circuit MAₓ. Propagation time to of the additional delay circuit T_{Dx} is four times longer than the nominal propagation delay t_{N} of the main MUTEX circuit MMₓ and is shorter than the propagation time t_{M} of the first delay circuit T_{M1x} and of the second delay circuit T_{M2x}. In this exemplary system the main MUTEX circuit MMₓ and the additional MUTEX circuit MAₓ are known MUTEX circuits including asynchronous RS flip-flops composed of NAND logic gates and simple filters (fig.2). The first output Q1 of the main MUTEX circuit MMₓ is connected to a data input Dₓ of an output module OM and to a first input of a second gate B2ₓ, whose second input is connected to the second output Q2 of the main MUTEX circuit MMₓ. An output of the second gate B2ₓ is in turn connected to a set input S of the additional MUTEX circuit MAₓ, whose second output Q2 is connected to a priority input Prtₓ of the output module OM. The output module OM is furthermore provided with outputs of bits bₙ₋₁, ..., b₀ of the n-bit output digital word B. In this exemplary system, the first gate B1ₓ and the second gate B2ₓ are OR logic gates.

In a second exemplary solution, the system for recognizing an order of signals according to the invention differs from the first one in that the main MUTEX circuit MMₓ and the additional MUTEX circuit MAₓ are known MUTEX circuits including asynchronous RS flip-flops composed of NOR logic gates and inverted filters (fig. 3). Moreover, in this exemplary solution, the first gate B1ₓ and the second gate B2ₓ are AND logic gates.

Recognition of an order of signals implemented, according to the invention, in the first exemplary system (fig. 1) proceeds as follows. The MUTEX circuit indicates, as the leading signal, the signal which enters its active state earlier. It happens so, however, provided that both signals do not enter their active states quasi-simultaneously. The first of the considered signals is the source signal Scₓ, and the second is the reference signal Rfₓ. In the first exemplary system the active state is a logical high state.

In the case where the source signal Scₓ and the reference signal Rfₓ do not enter their active states quasi-simultaneously, a time interval ΔT separating activation moments of these signals (fig. 4) has little effect on length of a propagation delay t_{P} (fig. 5) with which the main MUTEX circuit MMₓ reacts on the appearance of the leading signal by activating one of its two outputs. The propagation delay of the main MUTEX circuit MMₓ in such case is equal or slightly larger than the nominal propagation delay t_{N} of the main MUTEX circuit MMₓ (fig. 5) and is shorter than the propagation time to of the additional delay circuit T_{Dx} (fig. 5). If the leading signal is the source signal Scₓ, then the first output Q1 of the main MUTEX circuit MMₓ will be put into active state. If, however, the leading signal is the reference signal Rfₓ, then the second output Q2 of the main MUTEX circuit MMₓ will be put into active state. Later entering active state by the second of the signals has no influence on the already established state of the outputs of the main MUTEX circuit MMₓ. In the case where the leading signal is the source signal Scₓ, the active state of the first output Q1 of the main MUTEX circuit MMₓ, fed to the first control input C1 of the path configuration circuit Eₓ causes a reference delay, having length suitable for a given analog-to-digital converter cell, to be included in a path of the source signal Scₓ. Simultaneously, a path of the reference signal Rfₓ will not include the reference delay. Otherwise, when the leading signal is the reference signal Rfₓ, the active state of the second output Q2 of the main MUTEX circuit MMₓ, fed to the second control input C2 of the path configuration circuit Eₓ, causes the reference delay to be included in the path of the reference signal Rfₓ. Simultaneously, the path of the source signal SCₓ will not include the reference delay. The source signal Scₓ and the reference signal Rfₓ are fed to, respectively, the input of the source path Sc_{In} of the path configuration circuit Eₓ and the input of the reference path Rfₗₙ of the path configuration circuit Eₓ through the first delay circuit T_{M1x} and the second delay circuit T_{M2x}, respectively. In the considered case the propagation delay t_{P} of the main MUTEX circuit MMₓ is shorter than the propagation times t_{M} of the first delay circuit T_{M1x} and of the second delay circuit T_{M2x} (fig. 5). Therefore, each of the signals reaches the input of its own path in the path configuration circuit Eₓ only when both paths have been previously properly configured, what is necessary for proper operation of the analog-to-digital converter.

The length of the propagation delay t_{P} of the main MUTEX circuit MMₓ is always controlled by means of the additional MUTEX circuit MAₓ. The beginning of an interval of the propagation delay t_{P} of the main MUTEX circuit MMₓ is indicated by means of the first gate B1ₓ, whose output enters active state as a result of the appearance of the leading signal at either of the two inputs of this gate. An output signal of the first gate B1ₓ is delayed by means of the additional delay circuit T_{Dx} and eventually reaches the reset input R of the additional MUTEX circuit MAₓ. The end of the interval of the propagation delay t_{P} of the main MUTEX circuit MMₓ is indicated by means of the second gate B2ₓ, whose output enters active state as a result of the appearance of the active state at either of the two outputs of the main MUTEX circuit MMₓ. An output signal of the second gate B2ₓ is fed to the set input S of the additional MUTEX circuit MAₓ. Propagation delays of the first gate B1ₓ and of the second gate B2ₓ are identical and compensate each other. The propagation delay t_{P} of the main MUTEX circuit MMₓ is in turn, in the considered case, shorter than the propagation time to of the additional delay circuit T_{Dx} (fig. 5). Therefore, the set input S of the additional MUTEX circuit MAₓ will be put into active state first. Thereby, the active state will eventually appear on an unused first output Q1 of the additional MUTEX circuit MAₓ. The second output Q2 of the additional MUTEX circuit MAₓ will remain in inactive state also when the active state of the additional delay circuit T_{Dx} eventually reaches the reset input R of the additional MUTEX circuit MAₓ. Thereby the priority input Prtₓ of the output module OM will be constantly kept in inactive state and will not affect in any way the value given to the bit bₓ by the output module OM. The value of this bit will be only influenced by the state of the first output Q1 of the main MUTEX circuit MMₓ, fed to the data input Dₓ of the output module OM. If the data input Dₓ of the output module OM is in inactive state, then a logical state zero is assigned to the bit bₓ by means of the output module OM. Otherwise, when the data input Dₓ of the output module OM is in active state, a logical state one is assigned to the bit bₓ by means of the output module OM.

In the case where the source signal Scₓ and the reference signal Rfₓ enter their active states quasi-simultaneously, the main MUTEX circuit MMₓ exhibits metastability. The propagation delay t_{P} of the main MUTEX circuit MMₓ rapidly increases (fig. 5) and becomes longer than the propagation time to of the additional delay circuit T_{Dx}. The propagation delay t_{P} of the main MUTEX circuit MMₓ may then become longer than the propagation time t_{M} of the first delay circuit T_{M1x} and of the second delay circuit T_{M2x} (fig. 5). In such case the source signal Scₓ and the reference signal Rfₓ reach the input of the source path Sc_{In} of the path configuration circuit Eₓ and the input of the reference path Rfₗₙ of the path configuration circuit Eₓ, respectively, even before the active state appears on one of the outputs of the main MUTEX circuit MMₓ. Quasi-simultaneous: the source signal Scₓ and the reference signal Rfₓ therefore propagate through paths which have not yet been properly configured by means of the path configuration circuit Eₓ. Analog-to-digital conversion algorithm of the successive approximation method does not anticipate such a situation, and its occurrence causes falsification of the correct value of the determined output digital word B. At the same time, however, quasi-simultaneity of the source signal Scₓ and of the reference signal Rfₓ means that in the previously performed steps of processing the positions of both signals have been already managed to align in the time domain, in addition, with an accuracy better than the resolution of a given converter. This situation can only occur when the measured time interval ΔT was initially quasi-equal to 1/2 of the processing range, or 1/4 of the processing range, or 3/4 of the processing range, or 1/8 of the processing range, etc.

So if the ideal analog-to-digital converter in which the main MUTEX circuit MMₓ is completely metastability-free, encountered quasi-simultaneity of the source signal Scₓ and of the reference signal Rfₓ in a processing step used to determine the bit having index x bₓ, then such a converter in this processing step would include the reference delay in a path of one of the signals, and in each of subsequent processing steps it would include the reference delays of twice decreasing lengths in a path of the second of the signals, trying to realign the positions of these signals in time domain. Therefore it is certain that in the output digital word B of the ideal analog-to-digital converter, values of the bit bₓ and of all possible less significant bits bₓ₋₁, ..., b₀ must take one of two sequences: 0, 1, 1, ..., 1 or 1, 0, 0, ..., 0. Moreover, in case the source signal Scₓ and the reference signal Rfₓ enter their active state simultaneously, both of the above sequences are equally likely. In the considered case, the result of analog-to-digital conversion can therefore be predicted with an accuracy to one, without carrying out the remaining steps of this process or omitting their results, which will turn out to be falsified for the real converter anyway due to metastability of the MUTEX circuit.

The metastability of the main MUTEX circuit MMₓ is detected and signaled by means of the additional MUTEX circuit MAₓ. In the considered case the propagation delay t_{P} of the main MUTEX circuit MMₓ is longer than the propagation time t_{M} of the additional delay circuit T_{Dx} (fig. 5). Therefore, the reset input R of the additional MUTEX circuit MAₓ will be put into active state first. Thereby, the active state will appear on the second output Q2 of the additional MUTEX circuit MAₓ and will be forwarded to the priority input Prtₓ of the output module OM, signaling the metastability of the main MUTEX circuit MMₓ to the output module OM. As a result of the above, the output module OM will immediately assign default values to the bit bₓ and to all possible less significant bits bₓ₋₁, ..., b₀ of the output digital word B. Moreover, starting from this point of time, the output module OM will ignore the state of its data input Dₓ, both at that processing stage and at any subsequent processing stage. The output module OM will therefore assign a logical state zero to the bit bₓ, and the output module OM will assign logical states one to all possible less significant bits bₓ₋₁, ..., b₀ of the output digital word B. The final value of the output digital word B will be equal to or one less than the value of the output digital word B, which would be obtained in an ideal analog-to-digital converter. In another exemplary solution, the output module OM will assign a logical state one to the bit bₓ, and the output module OM will assign logical states zero to all possible less significant bits bₓ₋₁, ..., b₀ of the output digital word B. In this solution, the final value of the output digital word B will therefore be equal to or one greater than the value of the output digital word B, which would be obtained in an ideal analog-to-digital converter.

In a particular case the propagation delay t_{P} of the main MUTEX circuit MMₓ is quasi-equal to the propagation time to of the additional delay circuit T_{Dx} (fig. 5). The propagation delay t_{P} of the main MUTEX circuit MMₓ is therefore shorter than the propagation times t_{M} of the first delay circuit T_{M1x} and the second delay circuit T_{M2x} (fig. 5). Therefore, the source signal Scₓ and the reference signal Rfₓ reach the input of the source path Sc_{In} of the path configuration circuit Eₓ and the input of the reference path Rfₗₙ of the path configuration circuit Eₓ, respectively, only when the main MUTEX circuit MMₓ has already put the appropriate control input of the path configuration circuit Eₓ into the active state. The source signal Scₓ and the reference signal Rfₓ therefore propagate through paths configured properly and in advance as required. So the analog-to-digital conversion process is working properly, and the output module OM can use the state of the first output Q1 of the main MUTEX circuit MMₓ to assign the appropriate value to the bit having index x, bₓ, of the output digital word B.

As in any case, the length of the propagation delay t_{P} of the main MUTEX circuit MMₓ is controlled by means of the additional MUTEX circuit MAₓ. In the particular case under consideration, the propagation delay t_{P} of the main MUTEX circuit MMₓ is quasi-equal to the propagation time to of the additional delay circuit T_{Dx} (fig. 5). Therefore, the set input S of the additional MUTEX circuit MAₓ and the reset input R of the additional MUTEX circuit MAₓ are put into their active states quasi-simultaneously, causing metastability of the additional MUTEX circuit MAₓ. The result of it is a significant extension of the propagation delay of the additional MUTEX circuit MAₓ and the inability to unambiguously indicate the output of the additional MUTEX circuit MAₓ, which will eventually be put into active state. If the active state appears on the unused first output Q1 of the additional MUTEX circuit MAₓ, the priority input Prtₓ of the output module OM will still be kept in inactive state by means of the second output Q2 of the additional MUTEX circuit MAₓ. The values of the bit having index x, bₓ, and of a part of possible less significant bits bₓ₋₁, bₓ₋₂, ..., of the output digital word B, already determined as a result of the analog-to-digital conversion process, which is still running correctly, will therefore be kept. If, however, the active state eventually appears on the second output Q2 of the additional MUTEX circuit MAₓ, then the priority input Prtₓ of the output module OM will be put into active state, signaling potential metastability of the main MUTEX circuit MMₓ to the output module OM. As a result of the above, the output module OM will assign default values to the bit bₓ and to all possible less significant bits bₓ₋₁, ..., b₀ of the output digital word B. Moreover, the output module OM will ignore the state of its data input Dₓ, both at that processing stage and at any subsequent processing stage. The output module OM will therefore assign a logical state zero to the bit bₓ, and the output module OM will assign logical states one to all possible less significant bits bₓ₋₁, ..., b₀ of the output digital word B. The value of the output digital word B obtained in this way will be equal to or one less than the value of the output digital word B, that would be obtained by continuing the normal analog-to-digital conversion process. In another exemplary solution, the output module OM will assign a logical state one to the bit bₓ, and the output module OM will assign logical states zero to all possible less significant bits bₓ₋₁, ..., b₀ of the output digital word B. In this solution, the final value of the output digital word B will therefore be equal to or one greater than the value of the output digital word B, that would be obtained by continuing the normal analog-to-digital conversion process.

Recognition of an order of signals implemented, according to the invention, in the second exemplary system proceeds in an identical manner as in the first exemplary system (fig. 1), with the only difference that the active state is a logical low state.

## Claims

1. A method for recognizing an order of signals, consisting in detecting, by means of a main MUTEX circuit, executed during an analog-to-digital conversion step used to determine a value of a bit having index x of an n-bit output digital word, that a source signal was the first to enter its active state, or that a reference signal was the first to enter its active state, and signaling by means of a first output of the main MUTEX circuit to a path configuration circuit that the source signal was the first to enter its active state, or signaling by means of a second output of the main MUTEX circuit to the path configuration circuit, that the reference signal was the first to enter its active state, wherein the source signal is fed by means of a first delay circuit to an input of a source path of the path configuration circuit and simultaneously the reference signal is fed by means of a second delay circuit to an input of a reference path of the path configuration circuit, wherein propagation time of the first delay circuit is equal to propagation time of the second delay circuit and is longer than a nominal propagation delay of the main MUTEX circuit, **characterized in that** metastability of the main MUTEX circuit (MMₓ) is detected by means of an additional MUTEX circuit (MAₓ), by controlling the delay with which the first output (Q1) of the main MUTEX circuit (MMₓ) or a second output (Q2) of the main MUTEX circuit (MMₓ) is put into active state by means of the main MUTEX circuit (MMₓ), relative to the time in which the source signal (Scₓ) was the first to enter its active state or the reference signal (Rfₓ) was the first to enter its active state, wherein the metastability of the main MUTEX circuit (MMₓ) is signaled by means of the additional MUTEX circuit (MAₓ) by bringing a second output (Q2) of the additional MUTEX circuit (MAx) into active state, whereas entering active state by the source signal (Scₓ) or entering active state by the reference signal (Rfₓ) is detected by means of a first gate (B1ₓ) and is signaled by means of an additional delay circuit (T_{Dx}) to the additional MUTEX circuit (MAₓ), bringing a reset input (R) of the additional MUTEX circuit (MAₓ) into active state, wherein propagation time (to) of the additional delay circuit (T_{Dx}) is shorter than the propagation time (t_{M}) of the first delay circuit (t_{M1x}) and simultaneously is longer than the nominal propagation delay (t_{N}) of the main MUTEX circuit (MMₓ), whereas entering active state by the first output (Q1) of the main MUTEX circuit (MMx) or entering active state by the second output (Q2) of the main MUTEX circuit (MMₓ) is detected and is signaled by means of a second gate (B2ₓ) to the additional MUTEX circuit (MAₓ), bringing a set input (S) of the additional MUTEX circuit (MAₓ) into active state, whereas to the bit having index x (bₓ) of the n-bit output digital word (B) a value is assigned by means of an output module (OM) in such a way that if during the analog-to-digital conversion step used to determine the value of the bit having index x (bₓ) of the n-bit output digital word (B) metastability of the main MUTEX circuit (MMₓ) is signaled by means of the additional MUTEX circuit (MAₓ) and a priority input (Prtₓ) of the output module (OM) is put into active state by means of the second output (Q2) of the additional MUTEX circuit (MAₓ), then to the bit having index x (bₓ) and to all possible less significant bits (bₓ₋₁, ..., b₀) of the n-bit output digital word (B) default logical states are assigned by means of the output module (OM) and simultaneously the state indicated by means of the first output (Q1) of the main MUTEX circuit (MMₓ) to a data input (Dₓ) of the output module (OM) is ignored by the output module (OM) during this and any subsequent analog-to-digital conversion steps, if, however, during the analog-to-digital conversion step used to determine the value of the bit having index x (bₓ) of the n-bit output digital word (B) metastability of the main MUTEX circuit (MMx) is not signaled by means of the additional MUTEX circuit (MAₓ) and the priority input (Prtₓ) of the output module (OM) is kept in inactive state by means of the second output (Q2) of the additional MUTEX circuit (MAₓ) and metastability is not signaled during any of possible earlier analog-to-digital conversion steps used to determine values of more significant bits (bₙ₋₁, ..., bₓ₊₁) of the n-bit output digital word (B), then to the bit having index x (bₓ) of the n-bit output digital word (B) a logical state according to the state of the data input (Dₓ) of the output module (OM) is assigned by means of the output module (OM), in such a way that if the data input (Dₓ) of the output module (OM) is put into active state by means of the first output (Q1) of the main MUTEX circuit (MMₓ), then to the bit having index x (bₓ) of the n-bit output digital word (B) a logical state one is assigned by means of the output module (OM), and otherwise, when the data input (Dₓ) of the output module (OM) is kept in the inactive state by means of the first output (Q1) of the main MUTEX circuit (MMx), to the bit having index x (bₓ) of the n-bit output digital word (B) a logical state zero is assigned by means of the output module (OM).

2. The method according to claim 1, **characterized in that** the active state of the source signal (Scₓ), of the reference signal (Rfₓ), of the first output (Q1) of the main MUTEX circuit (MMₓ) and of the second output (Q2) of the main MUTEX circuit (MMₓ) as well as of a first output (Q1) of the additional MUTEX circuit (MAₓ) and of the second output (Q2) of the additional MUTEX circuit (MMₓ) is a logical high state, whereas by means of the first gate (B1) and by means of the second gate (B2) a logical OR function is implemented.

3. The method according to claim 1, **characterized in that** the active state of the source signal (Scₓ), of the reference signal (Rfₓ), of the first output (Q1) of the main MUTEX circuit (MMₓ) and of the second output (Q2) of the main MUTEX circuit (MMₓ) as well as of the first output (Q1) of the additional MUTEX circuit (MAₓ) and of the second output (Q2) of the additional MUTEX circuit (MMₓ) is a logical low state, whereas by means of the first gate (B1) and by means of the second gate (B2) a logical AND function is implemented.

4. The method according to claim 2 or 3, **characterized in that** the default logical states are assigned by means of the output module (OM) to selected bits of the n-bit output digital word (B) in such a way that to the bit having index x (bₓ) of the n-bit output digital word (B) a logical state zero is assigned by means of the output module (OM), and to all possible less significant bits (bₓ₋₁, ..., b₀) of the n-bit output digital word (B) logical states one are assigned by means of the output module (OM).

5. The method according to claim 2 or 3, **characterized in that** the default logical states are assigned by means of the output module (OM) to selected bits of the n-bit output digital word (B) in such a way that to the bit having index x (bₓ) of the n-bit output digital word (B) a logical state one is assigned by means of the output module (OM), and to all possible less significant bits (bₓ₋₁, ..., b₀) of the n-bit output digital word (B) logical states zero are assigned by means of the output module (OM).

## Patentansprüche

1. Verfahren zum Erkennen einer Signalreihenfolge, basierend auf Detektion, mittels einer Haupt-MUTEX-Schaltung, die während eines Analog-Digital-Umwandlungsschritts ausgeführt wird, der zum Bestimmen eines Werts eines Bits mit Index x eines n-Bit-Ausgangsdigitalworts verwendet wird, dass ein Quellsignal als erstes seinen aktiven Zustand eingenommen hat oder dass ein Referenzsignal als erstes seinen aktiven Zustand eingenommen hat, und zum Signalisieren mittels eines ersten Ausgangs der Haupt-MUTEX-Schaltung an eine Pfadkonfigurationsschaltung, dass das Quellsignal als erstes seinen aktiven Zustand eingenommen hat, oder zum Signalisieren mittels eines zweiten Ausgangs der Haupt-MUTEX-Schaltung an die Pfadkonfigurationsschaltung, dass das Referenzsignal als erstes seinen aktiven Zustand eingenommen hat, wobei das Quellsignal mittels einer ersten Verzögerungsschaltung einem Eingang eines Quellpfads der Pfadkonfigurationsschaltung zugeführt wird und gleichzeitig das Referenzsignal mittels einer zweiten Verzögerungsschaltung einem Eingang eines Referenzpfads der Pfadkonfigurationsschaltung zugeführt wird, wobei die Ausbreitungszeit der ersten Verzögerungsschaltung gleich der Ausbreitungszeit der zweiten Verzögerungsschaltung ist und länger als eine nominale Ausbreitungsverzögerung der Haupt-MUTEX-Schaltung ist, **dadurch gekennzeichnet, dass** die Metastabilität der Haupt-MUTEX-Schaltung (MMₓ) mittels einer zusätzlichen MUTEX-Schaltung (MAₓ) erkannt wird, indem die Verzögerung gesteuert wird, mit der der erste Ausgang (Q1) der Haupt-MUTEX-Schaltung (MMₓ) oder der zweite Ausgang (Q2) der Haupt-MUTEX-Schaltung (MMₓ), mittels der Haupt-MUTEX-Schaltung (MMₓ), in den aktiven Zustand versetzt wird, relativ zu der Zeit, in der das Quellensignal (Scₓ) als erstes seinen aktiven Zustand eingenommen hat oder das Referenzsignal (Rfₓ) als erstes seinen aktiven Zustand eingenommen hat, wobei die Metastabilität der Haupt-MUTEX-Schaltung (MMₓ) mittels der zusätzlichen MUTEX-Schaltung (MAₓ) signalisiert wird, indem ein zweiter Ausgang (Q2) der zusätzlichen MUTEX-Schaltung (MAₓ) in den aktiven Zustand versetzt wird, während das Eintreten des aktiven Zustands durch das Quellensignal (Scₓ) oder das Eintreten des aktiven Zustands durch das Referenzsignal (Rfₓ) mittels eines ersten Gatters (B1ₓ) erkannt wird, und mittels einer zusätzlichen Verzögerungsschaltung (T_{Dx}) an die zusätzliche MUTEX-Schaltung (MAₓ) signalisiert ist, indem ein Rücksetzeingang (R) der zusätzlichen MUTEX-Schaltung (MAₓ) in den aktiven Zustand versetzt wird, wobei die Ausbreitungszeit (t_{D}) der zusätzlichen Verzögerungsschaltung (T_{Dx}) kürzer als die Ausbreitungszeit (t_{M}) der ersten Verzögerungsschaltung (t_{M1x}) ist und gleichzeitig länger als die nominale Ausbreitungsverzögerung (I_{N}) der Haupt-MUTEX-Schaltung (MMₓ) ist, wobei das Eintreten des aktiven Zustands durch den ersten Ausgang (Q1) der Haupt-MUTEX-Schaltung (MMₓ) oder das Eintreten des aktiven Zustands durch den zweiten Ausgang (Q2) der Haupt-MUTEX-Schaltung (MMₓ) mittels des zweiten Gatters (B2ₓ) erkannt und der zusätzlichen MUTEX-Schaltung (MAₓ) signalisiert wird, indem der Setzeingang (S) der zusätzlichen MUTEX-Schaltung (MAₓ) in den aktiven Zustand versetzt wird, wobei dem Bit mit dem Index x (bₓ) des n-Bit-Ausgangsdigitalworts (B) mittels eines Ausgabemoduls (OM) ein Wert so zugewiesen wird, dass wenn während des Analog-Digital-Umwandlungsschritts zur Bestimmung des Wertes des Bits mit dem Index x (bₓ) des n-Bit-Ausgangsdigitalworts (B) die Metastabilität der Haupt-MUTEX-Schaltung (MMₓ) mittels der zusätzlichen MUTEX-Schaltung (MAₓ) signalisiert wird und ein Prioritätseingang (Prtₓ) des Ausgabemoduls (OM) mittels des zweiten Ausgangs (Q2) der zusätzlichen MUTEX-Schaltung (MAₓ) in den aktiven Zustand versetzt wird, dann dem Bit mit dem Index x (bₓ) und allen möglichen niederwertigen Bits (bₓ₋₁, ..., b₀) des n-Bit-Ausgangsdigitalworts (B) mittels des Ausgabemoduls (OM) standardmäßige logische Zustände zugewiesen werden und gleichzeitig der mittels des ersten Ausgangs (Q1) der Haupt-MUTEX-Schaltung (MMₓ) einem Dateneingang (Dₓ) des Ausgabemoduls (OM) angezeigte Zustand vom Ausgabemodul (OM) während dieses und aller nachfolgenden Analog-Digital-Umwandlungsschritte ignoriert wird, wenn jedoch während des Analog-Digital-Umwandlungsschritts zur Bestimmung des Wertes des Bits mit dem Index x (bₓ) des n-Bit-Ausgangsdigitalworts (B) die Metastabilität der Haupt-MUTEX-Schaltung (MMₓ) nicht mittels der zusätzlichen MUTEX-Schaltung (MAₓ) signalisiert wird und der Prioritätseingang (Prtₓ) des Ausgabemoduls (OM) mittels des zweiten Ausgangs (Q2) der zusätzlichen MUTEX-Schaltung (MAₓ) im inaktiven Zustand gehalten wird und die Metastabilität während keinem der möglichen früheren Analog-Digital-Umwandlungsschritte signalisiert wird, die zur Bestimmung der Werte der höherwertigen Bits (bₙ₋₁, ..., bₓ₊₁) des n-Bit-Ausgangsdigitalworts (B) verwendet werden, dann dem Bit mit dem Index x (bₓ) des n-Bit-Ausgangsdigitalworts (B) mittels des Ausgabemoduls (OM) ein logischer Zustand entsprechend dem Zustand des Dateneingangs (Dₓ) des Ausgabemoduls (OM) zugewiesen wird, und zwar so, dass, wenn der Dateneingang (Dₓ) des Ausgabemoduls (OM) mittels des ersten Ausgangs (Q1) der Haupt-MUTEX-Schaltung in den aktiven Zustand versetzt wird (MMₓ), dann dem Bit mit dem Index x (bₓ) des n-Bit-Ausgangsdigitalworts (B) mittels des Ausgabemoduls (OM) ein logischer Zustand Eins zugewiesen wird, und anderenfalls, wenn der Dateneingang (Dₓ) des Ausgabemoduls (OM) mittels des ersten Ausgangs (Q1) der Haupt-MUTEX-Schaltung (MMₓ) im inaktiven Zustand gehalten wird, dem Bit mit dem Index x (bₓ) des n-Bit-Ausgangsdigitalworts (B) mittels des Ausgabemoduls (OM) ein logischer Zustand Null zugewiesen wird.

2. Verfahren nach Anspruch 1, **dadurch gekennzeichnet, dass** der aktive Zustand des Quellsignals (Scₓ), des Referenzsignals (Rfₓ), des ersten Ausgangs (Q1) der Haupt-MUTEX-Schaltung (MMₓ) und des zweiten Ausgangs (Q2) der Haupt-MUTEX-Schaltung (MMₓ) sowie eines ersten Ausgangs (Q1) der zusätzlichen MUTEX-Schaltung (MAₓ) und des zweiten Ausgangs (Q2) der zusätzlichen MUTEX-Schaltung (MMₓ) ein logisch hoher Zustand ist, wobei mittels des ersten Gatters (B1) und mittels des zweiten Gatters (B2) eine logische ODER-Funktion implementiert wird.

3. Verfahren nach Anspruch 1, **dadurch gekennzeichnet, dass** der aktive Zustand des Quellsignals (Scₓ), des Referenzsignals (Rfₓ), des ersten Ausgangs (Q1) der Haupt-MUTEX-Schaltung (MMₓ) und des zweiten Ausgangs (Q2) der Haupt-MUTEX-Schaltung (MMₓ) sowie des ersten Ausgangs (Q1) der zusätzlichen MUTEX-Schaltung (MAₓ) und des zweiten Ausgangs (Q2) der zusätzlichen MUTEX-Schaltung (MMₓ) ein logisch niedriger Zustand ist, wobei mittels des ersten Gatters (B1) und mittels des zweiten Gatters (B2) eine logische UND-Funktion implementiert wird.

4. Verfahren nach Anspruch 2 oder 3, **dadurch gekennzeichnet dass,** die vorgegebenen logischen Zustände derart zugewiesen werden, mittels des Ausgabemoduls (OM) ausgewählten Bits des n-Bit-Ausgangsdigitalworts (B) dass dem Bit mit dem Index x (bₓ) des n-Bit-Ausgangsdigitalworts (B) mittels des Ausgabemoduls (OM) ein logischer Zustand Null zugewiesen wird und allen möglichen niederwertigen Bits (bₓ₋₁, ..., b₀) des n-Bit-Ausgabedigitalworts (B) mittels des Ausgabemoduls (OM) logische Zustände Eins zugewiesen werden.

5. Verfahren nach Anspruch 2 oder 3, **dadurch gekennzeichnet, dass** die vorgegebenen logischen Zustände mittels des Ausgabemoduls (OM) ausgewählten Bits des n-Bit-Ausgangsdigitalworts (B) derart zugewiesen werden, dass dem Bit mit dem Index x (bₓ) des n-Bit-Ausgangsdigitalworts (B) mittels des Ausgabemoduls (OM) ein logischer Zustand Eins zugewiesen wird und allen möglichen niederwertigen Bits (bₓ₋₁, ..., b₀) des n-Bit-Ausgangsdigitalworts (B) mittels des Ausgabemoduls (OM) logische Zustände Null zugewiesen werden.

## Revendications

1. Procédé de reconnaissance d'un ordre de signaux, consistant à détecter, au moyen d'un circuit MUTEX principal, exécuté lors d'une étape de conversion analogique-numérique, servant à déterminer une valeur d'un bit ayant l'indice x d'un mot numérique de sortie de n bits, qu'un signal de source a été le premier à entrer dans son état actif, ou qu'un signal de référence a été le premier à entrer dans son état actif, et servant à signaler au moyen d'une première sortie du circuit MUTEX principal à un circuit de configuration de trajet, que le signal de source a été le premier à entrer dans son état actif, ou servant à signaler, au moyen d'une deuxième sortie du circuit MUTEX principal à un circuit de configuration de trajet, que le signal de référence a été le premier à entrer dans son état actif, le signal de source étant envoyé par au moyen d'un premier circuit à retard à une entrée d'un trajet de source du circuit de configuration de trajet et simultanément le signal de référence est envoyé au moyen d'un deuxième circuit à retard à une entrée d'un trajet de référence du circuit de configuration de trajet, le temps de propagation du premier circuit à retard est égal au temps de propagation du deuxième circuit à retard et est plus long que le retard de propagation nominal du circuit MUTEX principal, **caractérisé en ce que** la métastabilité du circuit MUTEX principal (MMₓ) est détectée au moyen d'un circuit MUTEX supplémentaire (MAₓ), en contrôlant le retard avec lequel la première sortie (Q1) du circuit MUTEX principal (MMₓ) ou la deuxième sortie (Q2) du circuit MUTEX principal (MMₓ) devient active au moyen du circuit MUTEX principal (MMₓ), par rapport au moment où le signal de source (Scₓ) a été le premier à entrer dans son état actif ou le signal de référence (Rfₓ) a été le premier à entrer dans son état actif, dans lequel la métastabilité du circuit MUTEX principal (MMₓ) est signalée au moyen du circuit MUTEX supplémentaire (MAₓ) en amenant une deuxième sortie (Q2) du circuit MUTEX supplémentaire (MAₓ) dans l'état actif, tandis que l'entrée dans l'état actif par le signal source (Scₓ) ou l'entrée dans l'état actif par le signal de référence (Rfₓ) est détectée au moyen d'une première porte (B1ₓ) et est signalée au moyen d'un circuit à retard supplémentaire (T_{Dx}) au circuit MUTEX supplémentaire (MAₓ), amenant une entrée de réinitialisation (R) du circuit MUTEX supplémentaire (MAₓ) à un état actif, le temps de propagation (t_{D}) du circuit à retard supplémentaire (T_{Dx}) étant plus court que le temps de propagation (t_{M}) du premier circuit à retard (t_{M1x}) et simultanément est plus long que le retard de propagation nominal (t_{N}) du circuit MUTEX principal (MMₓ), alors que l'entrée dans l'état actif par la première sortie (Q1) du circuit MUTEX principal (MMₓ) ou l'entrée en état actif par la deuxième sortie (Q2) du circuit MUTEX principal (MMx) est détectée et signalée au moyen d'une deuxième porte (B2x) au circuit MUTEX supplémentaire (MAx), amenant une entrée de réglage (S) du circuit MUTEX supplémentaire (MAₓ) dans l'état actif, tandis qu'au bit ayant l'indice x (bₓ) du mot numérique de sortie (B) de n bits, une valeur est attribuée au moyen d'un module de sortie (OM) de telle sorte que si pendant l'étape de conversion analogique-numérique utilisée pour déterminer la valeur du bit ayant l'indice x (bₓ) du mot numérique de sortie (B) de n bits, la métastabilité du circuit MUTEX principal (MMₓ) est signalée au moyen du circuit MUTEX supplémentaire (MAₓ) et une entrée prioritaire (Prtₓ) du module de sortie (OM) est mise à l'état actif au moyen de la deuxième sortie (Q2) du circuit MUTEX supplémentaire (MAₓ), puis au bit ayant l'indice x (bₓ) et à tous les bits de poids faible possibles (bₓ₋₁, ..., b₀) du mot numérique de sortie (B) de n bits, des états logiques par défaut sont attribués au moyen du module de sortie (OM) et simultanément l'état indiqué au moyen de la première sortie (Q1) du circuit MUTEX principal (MMₓ) vers une entrée de données (Dₓ) du module de sortie (OM) est ignoré par le module de sortie (OM) pendant cette étape et toutes les étapes ultérieures possibles de conversion analogique-numérique, si toutefois, lors de l'étape de conversion analogique-numérique utilisée pour déterminer la valeur du bit ayant l'indice x (bₓ) du mot numérique de sortie (B) de n bits, la métastabilité du circuit MUTEX principal (MMₓ) n'est pas signalé au moyen du circuit MUTEX supplémentaire (MAₓ) et l'entrée prioritaire (Prtₓ) du module de sortie (OM) est maintenue à l'état inactif au moyen de la deuxième sortie (Q2) du circuit MUTEX supplémentaire (MAₓ) et la métastabilité n'est signalée lors d'aucune des étapes de conversion analogique-numérique antérieures possibles utilisées pour déterminer les valeurs des bits de poids fort (bₙ₋₁, ..., bₓ₊₁) du mot numérique de sortie (B) de n bits, puis pour au bit ayant l'indice x (bₓ) du mot numérique de sortie (B) de n bits, un état logique en fonction de l'état de l'entrée de données (Dₓ) du module de sortie (OM) est attribué au moyen du module de sortie (OM), de telle sorte que si l'entrée de données (Dₓ) du module de sortie (OM) est mise à l'état actif au moyen de la première sortie (Q1) du circuit MUTEX principal (MMₓ), alors au bit ayant l'indice x (bₓ) du mot numérique de sortie (B) de n bits, un état logique un est attribué au moyen du module de sortie (OM), et sinon, lorsque l'entrée de données (Dₓ) du module de sortie (OM) est conservée à l'état inactif au moyen de la première sortie (Q1) du circuit MUTEX principal (MMₓ), au bit ayant l'indice x (bₓ) du mot numérique de sortie (B) de n bits un état logique zéro est attribué au moyen du module de sortie (OM).

2. Procédé selon la revendication 1, **caractérisé en ce que** l'état actif du signal de source (Scₓ), du signal de référence (Rfₓ), de la première sortie (Q1) du circuit MUTEX principal (MMₓ) et de la deuxième sortie (Q2) du circuit MUTEX principal (MMₓ) et de la première sortie (Q1) du circuit MUTEX supplémentaire (MAₓ) et de la deuxième sortie (Q2) du circuit MUTEX supplémentaire (MMₓ) est un niveau logique haut état, tandis qu'au moyen de la première porte (B1) et au moyen de la deuxième porte (B2) une fonction OU logique est mise en oeuvre.

3. Procédé selon la revendication 1, **caractérisé en ce que** l'état actif du signal de source (Scₓ), du signal de référence (Rfₓ), de la première sortie (Q1) du circuit MUTEX principal (MMₓ) et de la deuxième sortie (Q2) du circuit MUTEX principal (MMₓ) et de la première sortie (Q1) du circuit MUTEX supplémentaire (MAₓ) et de la deuxième sortie (Q2) du circuit MUTEX supplémentaire (MMₓ) est un niveau logique bas état, tandis qu'au moyen de la première porte (B 1) et au moyen de la deuxième porte (B2) une fonction ET logique est implémentée.

4. Procédé selon la revendication 2 ou 3, **caractérisé en ce que** les états logiques par défaut sont attribués au moyen du module de sortie (OM) à des bits sélectionnés du mot numérique de sortie (B) de n bits de telle sorte qu'au bit ayant l'indice x (bₓ) du mot numérique de sortie (B) de n bits un état logique zéro est attribué au moyen du module de sortie (OM), et à tous les bits de poids faible possibles (bₓ₋₁, ..., b₀) du mot numérique de sortie (B) de n bits, les états logiques un sont attribués au moyen du module de sortie (OM).

5. Procédé selon la revendication 2 ou 3, **caractérisé en ce que** les états logiques par défaut sont attribués au moyen du module de sortie (OM) à des bits sélectionnés du mot numérique de sortie (B) de n bits de telle sorte qu'au bit ayant l'indice x (bₓ) du mot numérique de sortie (B) de n bits, un état logique un est attribué au moyen du module de sortie (OM), et à tous les bits de poids faible possibles (bₓ₋₁, ..., b₀) du mot numérique de sortie (B) de n bits les états logiques zéro sont attribués au moyen du module de sortie (OM).
